# EUROPÄISCHE PATENTANMELDUNG

(11) **EP 3 855 195 A1**
(43) Veröffentlichungstag der Anmeldung: **28.07.2021**
(21) Anmeldenummer: 21150841.1
(22) Anmeldetag: 11.01.2021
(51) Int. Cl.: G01R 31/34, H02P 25/08, H02P 27/00, F02N 11/04, F02N 11/10

(54) **VERFAHREN ZUR ELEKTRISCHEN FUNKTIONSPRÜFUNG EINER ELEKTRISCHEN RELUKTANZMASCHINE EINES KRAFTFAHRZEUGS**

(30) Priorität: 16.01.2020 DE 102020000236
(71) Anmelder: MAN Truck & Bus SE, 80995 München (DE)
(72) Erfinder: Kalaß, Rainer, 80995 München (DE); Lampalzer, Markus, 80995 München (DE)
(74) Vertreter: v. Bezold & Partner Patentanwälte - PartG mbB

(57) **Zusammenfassung**

Die Erfindung betrifft ein Verfahren (700) zur elektrischen Funktionsprüfung, vorzugsweise zur Windungsgüteprüfung, einer elektrischen Reluktanzmaschine eines Kraftfahrzeugs. Das Verfahren (700) umfasst ein Bereitstellen (701) der Reluktanzmaschine, aufweisend einen Rotor und einen Stator, in einem im Antriebsstrang des Kraftfahrzeugs eingebauten Zustand, und ein Einstellen (702) zumindest eines vordefinierten Rotorzustandes relativ zum Stator der Reluktanzmaschine. Das Verfahren umfasst ferner eine Durchführung (703) einer Stoßspannungsprüfung an der Reluktanzmaschine, während der zumindest eine vordefinierte Rotorzustand eingestellt ist, wobei mindestens eine im Rahmen der Stoßspannungsprüfung erzeugte Schwingungsantwort (1, 2, 3, 4) der Reluktanzmaschine erfasst und anhand vorbestimmter Vergleichskriterien (31, 51) ausgewertet wird, um festzustellen, ob ein Defekt der Reluktanzmaschine vorliegt oder nicht.

## Beschreibung

Die Erfindung betrifft ein Verfahren zur elektrischen Funktionsprüfung einer elektrischen Reluktanzmaschine eines Kraftfahrzeugs.

Elektrische Reluktanzmaschinen, nachfolgend kurz als Reluktanzmaschinen bezeichnet, sind aus dem Stand der Technik wohl bekannt. Im Antriebsstrang (nachfolgend auch kurz als Triebstrang bezeichnet) von Kraftfahrzeugen, beispielsweise Nutzfahrzeugen, mit einem Verbrennungsmotor als Hauptantrieb werden Reluktanzmaschinen, vorzugsweise mehrphasige Reluktanzmaschinen, zur Hybridisierung verbaut. Bei solch einer Reluktanzmaschine im Kraftfahrzeug kann es sich beispielsweise um einen Kurbelwellenstartergenerator (KSG), der zwischen dem Verbrennungsmotor und dem Getriebe, z. B. im Schwungradgehäuse, eingebaut ist, handeln.

Es besteht ein Bedarf, bei solchen Reluktanzmaschinen eine elektrische Funktionsprüfung, vorzugsweise eine Windungsgüteprüfung durchzuführen.

Durch die Integration der Reluktanzmaschine in den Triebstrang entstehen jedoch messtechnische Nachteile, weil nach bisher vorherrschender Meinung bestehende Messgeräte und Messverfahren zur Überprüfung der Windungsgüte nur bei ausgebautem Rotor aussagefähig sind. Diese aus der Praxis bekannten Messverfahren zur elektrischen Funktionsprüfung der Reluktanzmaschine vergleichen daher die Induktivitäten der Phasen der Reluktanzmaschine miteinander, ohne Rotor. Entsprechend werden diese Messverfahren nicht bei Reluktanzmaschinen angewandt, die sich in einem im Triebstrang eingebauten Zustand und somit in einem Zustand mit Rotor befinden.

In der Bandmontage von derartigen Triebsträngen von Kraftfahrzeugen kann daher derzeit keine Endabnahme, auch End-of-Line Prüfung genannt, der Reluktanzmaschine durchgeführt werden. Es kann zwar eine Prüfung allein des Stators in einem bestimmten Bandabschnitt durchgeführt werden, aber kein abschließendes Endabnahme-Prüfprotokoll im Ablieferwerk dokumentiert werden. Der Nachweis der bestimmungsgemäßen Funktion im Zusammenbau kann erst im fertig gestellten Kraftfahrzeug und damit im Kraftfahrzeugwerk durch die positiv verlaufende Inbetriebnahme nachgewiesen werden, wobei eine erfolgreiche Inbetriebnahme nur im Rahmen der Beobachtbarkeit der Systemfunktionen eine quantitative Aussage treffen kann. Eine prüfspannungsabhängig beobachtbare Vorschädigung der Wicklungsisolationen wird auch hier nicht vor der Auslieferung an den Kunden erkannt.

Ein aus der Praxis bekannter Ansatz ist daher, dass bei fertiggestellten Kraftfahrzeugen bei Auffälligkeiten der Reluktanzmaschine der Triebstrang entnommen und zerlegt wird. Die Reluktanzmaschine muss danach noch in ihre Einzelteile zerlegt werden. Das damit vereinzelte Statorpaket wird mittels elektrischer Funktionsprüfung in Form einer Stoßspannungsprüfung vermessen, z. B. mittels eines sog. Surge-Testgeräts (Stoßspannungstestgerät). Mit der Stoßspannungsprüfung können der Widerstand, die Isolation und/oder die Induktivität gemessen werden. Erst nach dieser Demontageabfolge mit abschließender elektrischer Prüfung wird überhaupt klar, ob die Zerlegung und der Austausch dieser Reluktanzmaschine notwendig war. Die elektrische Funktionsprüfung der Reluktanzmaschine erzeugt damit hohe Arbeitsaufwände. Nachteilig bei der Zerlegung im Feld sind sowohl die Dimensionen als auch deren Bauteilgewichte der Reluktanzmaschine, insbesondere bei Reluktanzmaschinen von Nutzfahrzeugen. Die Exposition der Wickelköpfe oder Windungsenden in Kombination mit der Wahrscheinlichkeit für Schädigungen durch eben diesen Ausbau sind hoch. Nur mit Handhabungsvorrichtungen zu manipulierende schwere Maschinenteile und alle weiteren Handlungen wie Rücktransport erhöhen also die Gefahr, dass die Reluktanzmaschine allein durch diese Vorgänge beschädigt oder sogar unbrauchbar wird, obwohl sie vorher unbeschädigt war.

Es ist somit eine Aufgabe der Erfindung, ein Verfahren zur elektrischen Funktionsprüfung einer elektrischen Reluktanzmaschine eines Kraftfahrzeugs bereitzustellen, mit dem Nachteile herkömmlicher Techniken vermieden werden können. Die Aufgabe der Erfindung ist es insbesondere, einen Ansatz zur elektrischen Funktionsprüfung einer elektrischen Reluktanzmaschine bereitzustellen, der eine effizientere Funktionsprüfung der Reluktanzmaschine bei der Endabnahme von Kraftfahrzeugen ermöglicht.

Diese Aufgaben werden durch ein Verfahren mit den Merkmalen des unabhängigen Anspruchs gelöst. Vorteilhafte Ausführungsformen und Anwendungen der Erfindung sind Gegenstand der abhängigen Ansprüche und werden in der folgenden Beschreibung unter teilweiser Bezugnahme auf die Figuren näher erläutert.

Die Erfindung zeichnet sich dadurch aus, dass ein Verfahren für eine Stoßspannungsprüfung an einer Reluktanzmaschine bereitgestellt wird, die im Antriebsstrang eines Kraftfahrzeugs eingebaut ist und die Stoßspannungsprüfung durchgeführt wird, während zumindest ein vordefinierter Rotorzustand eingestellt ist.

Bei der Ausarbeitung der Erfindung hat sich nämlich herausgestellt, dass bei einer elektrischen Funktionsprüfung einer elektrischen Reluktanzmaschine, aufweisend einen Rotor und einen Stator, in einem im Antriebsstrang des Kraftfahrzeugs eingebautem Zustand, qualitative Aussagen über das Vorliegen eines Windungsdefekts getätigt werden können, wenn die Funktionsprüfung zumindest eines vordefinierten Rotorzustandes relativ zum Stator der Reluktanzmaschine durchgeführt wird, beispielsweise mit einer vordefinierten Winkellage des Rotors relativ zum Stator und/oder einer vordefinierten Drehzahl des Rotors während der Funktionsprüfung durchgeführt wird.

So wurde einerseits festgestellt, dass bei einer Stoßspannungsprüfung, auch als Impulsprüfung bezeichnet, an einer im Antriebsstrang eingebauten Reluktanzmaschine sowohl die Streukapazität als auch die Induktivität zwischen Rotor und Stator, die zu Veränderungen der durch die Stoßspannung erzeugten Schwingungsantwort führen, in starker Abhängigkeit von der Winkellage des Rotors relativ zum Stator variieren. Diese Variation der elektrischen Streuwerte bedeutet, dass die während eines klassischen Impulstests erhaltene Antwortwellenform variiert, wodurch die Verwendung des herkömmlichen Wellenformvergleichsverfahrens der Phasen U,V,W als Gütevermessung eigentlich verhindert wird.

Jedoch wurde im Rahmen der Erfindung festgestellt, dass die Verteilungen dieser Werte signifikanter zwischen defekten und nicht defekten Windungen der Reluktanzmaschine variieren. Obwohl somit die Induktivitäts- und Kapazitätswerte (LC-Werte) sowie die Widerstands- und Kapazitätswerte (RC-Werte), die beispielsweise zum Quantifizieren von Antwortwellenformen verwendet werden können, auch aufgrund von Variationen dieser Wellenformen variieren, variieren aber die Verteilungen dieser Werte im Vergleich hierzu signifikanter zwischen defekten und nicht defekten Windungen in dieser Art der E-Motoren. Dies bedeutet, dass im Rahmen einer Stoßspannungsprüfung dennoch zuverlässig prüfspannungsabhängig beobachtbare Vorschädigungen der Reluktanzmaschine, vorzugsweise der Windungsgüte des Stators, erkannt werden können, wenn die Stoßspannungsprüfung in einem vordefinierten Rotorzustand oder mehreren vordefinierten Rotorzuständen relativ zum Stator durchgeführt wird und für diesen mindestens einen vordefinierten Rotorzustand vorbestimmte Vergleichskriterien herangezogen werden, um die Schwingungsantwort auszuwerten, dahingehend, ob die Schwingungsantwort einer defekten oder nicht defekten Reluktanzmaschine entspricht.

Beispielsweise kann der Rotor mittels manueller oder elektrischer Durchdrehvorrichtungen in eine definierte Winkellage positioniert werden oder mit einer bestimmten Drehzahl beaufschlagt und damit eine definierte Konjunktion oder Drehgeschwindigkeit der Rotorzähne zum Stator der Reluktanzmaschine erreicht werden. In der Folge werden die in der Regel störenden Streuwerte mittels empirischer Vermessung reproduzierbar und es kann, ohne Zerlegung des Triebstranges, treffsicher beurteilt werden, ob ein Defekt der Reluktanzmaschine, insbesondere in Form von Windungsschäden, vorliegt.

Voraussetzungen sind, dass es für die gegebene Reluktanzmaschine in eben diesem definierten Rotorzustand relativ zum Stator hinreichende und typische Vergleichskriterien für defekte und nicht defekte Teile gibt, die beispielsweise vorab empirisch anhand von Testmessungen bei diesem definierten Rotorzustand anhand von defekten und nicht defekten Reluktanzmaschinen ermittelt werden können. Unter einem Defekt können beispielsweise Beschädigungen der Windungen und eine damit verbundene Veränderung, beispielsweise ein Induktivitätsabfall, der Induktivität einzelner oder mehrere Spulen im Stator, beispielsweise durch Kurzschlüsse in den hochtemperaturlackisolierten Wicklungen oder auch Deformationen, Lageänderungen oder Korrosion, verstanden werden.

Daher wird gemäß einem ersten allgemeinen Gesichtspunkt der Erfindung ein Verfahren zur elektrischen Funktionsprüfung, vorzugsweise zur Windungsgüteprüfung, einer elektrischen Reluktanzmaschine eines Kraftfahrzeugs bereitgestellt. Das Verfahren umfasst das Bereitstellen der Reluktanzmaschine, aufweisend einen Rotor und einen Stator, in einem im Antriebsstrang des Kraftfahrzeugs eingebautem Zustand und das Einstellen zumindest eines vordefinierten Rotorzustandes relativ zum Stator der Reluktanzmaschine.

Das Verfahren umfasst ferner die Durchführung einer Stoßspannungsprüfung an der Reluktanzmaschine, während der zumindest eine vordefinierte Rotorzustand eingestellt ist, wobei mindestens eine im Rahmen der Stoßspannungsprüfung erzeugte Schwingungsantwort der Reluktanzmaschine erfasst und anhand vorbestimmter Vergleichskriterien ausgewertet wird, um festzustellen, ob ein Defekt der Reluktanzmaschine vorliegt oder nicht.

Dies bietet somit den besonderen Vorzug, dass die Funktionsprüfung der Reluktanzmaschine in eingebautem Zustand durchgeführt werden kann. Wie eingangs erläutert, ist dies besonders vorteilhaft zur End-of-Line-Prüfung, zur Prüfung in Service-Werkstätten und zur Vermeidung von Beschädigungen der Reluktanzmaschine, weil unnötige Ausbauvorgänge, wie es bisher Praxis ist, vermieden werden können.

Die elektrische Funktionsprüfung kann eine Windungsgüteprüfung sein. Die Windungsgüteprüfung kann Aufschluss darüber geben, ob an den geprüften Windungen der elektrischen Reluktanzmaschine ein Defekt vorliegt oder nicht. Unter Stoßspannungsprüfung versteht man in an sich bekannter Weise eine Prüfung, bei der eine Windung einer Statorwicklung der Reluktanzmaschine mit einem oder mehreren kurzen Spannungsimpulsen beaufschlagt, und eine entsprechende Schwingungsantwort in der geprüften Windung gemessen wird. Unter der Schwingungsantwort kann man die durch die Stoßspannung in der geprüften Windung erzeugte Spannung in Abhängigkeit von der Zeit verstehen. Der Verlauf der erzeugten Spannung kann einer gedämpften Sinuswelle entsprechen.

Der Antriebsstrang kann als hybridisierter Antriebsstrang ausgeführt sein, umfassend die Reluktanzmaschine und einen Verbrennungsmotor. Die Reluktanzmaschine kann hierbei als Kurbelwellenstartergenerator (KSG) ausgeführt sein. Der KSG ist koaxial zur Kurbelwelle und zwischen Motor und Getriebe angeordnet. Hierbei steht der KSG in Wirkverbindung mit der Kurbelwelle, beispielsweise indem der Rotor des KSGs im montierten Zustand mit einem auf der Kurbelwelle angeordneten Schwungrad drehfest in Verbindung steht. Der KSG kann im Schwungradgehäuse eingebaut sein oder an dieses angebaut sein. Das Kraftfahrzeug kann ein Nutzfahrzeug sein, vorzugsweise ein Lastkraftwagen oder Omnibus.

Der zumindest eine vordefinierte Rotorzustand kann zumindest eine vordefinierte Winkellage des Rotors relativ zum Stator sein. Die zumindest eine vordefinierte Winkellage kann entweder genau eine vordefinierte Winkellage des Rotors relativ zum Stator sein, oder mindestens zwei, vorzugsweise genau drei, vordefinierte Winkellagen des Rotors relativ zum Stator umfassen, wobei für jede der vordefinierten Winkellagen jeweils mindestens eine im Rahmen der Stoßspannungsprüfung erzeugte Schwingungsantwort erfasst und ausgewertet wird. Diese Winkellage(n) kann (können) mit einer manuellen, d. h. handbetätigten, Durchdrehvorrichtung, eingestellt werden, mittels der der Rotor bei abgeschaltetem Verbrennungsmotor verdreht werden kann, und eine Winkelskala eingestellt werden kann.

Entsprechend der zuvor beschriebenen Erkenntnisse ist es möglich, den Einfluss des eingebauten Rotors auf die Stoßspannungsprüfung für die vordefinierten Winkellagen zu reproduzieren und zu analysieren, um die vorbestimmten Vergleichskriterien entsprechend bereitstellen zu können.

Die wiederholte Durchführung von Stoßspannungsprüfungen für mehrere, vorzugsweise genau drei, vordefinierte Winkellagen führt zu einer höheren Genauigkeit des Verfahrens, d. h., es kann mit einer höheren Genauigkeit festgestellt werden, ob ein Defekt der Reluktanzmaschine vorliegt oder nicht.

Bei der Durchführung der Stoßspannungsprüfungen für vordefinierte Winkellagen befindet sich der Antriebsstrang im Stillstand. Alternativ oder zusätzlich kann der Rotor in der vordefinierten Winkellage kurzzeitig fixiert sein und eine Schwingungsantwort für jede Phase der Reluktanzmaschine erzeugt und erfasst werden. Damit ist gewährleistet, dass während der Durchführung der Schlussspannungsprüfung die vorbestimmte Winkellage des Rotors relativ zum Stator eingehalten wird, und keine Ungenauigkeiten des Prüfungsergebnisses durch ungewollte Bewegungen des Rotors auftreten.

Anstatt die vordefinierte Winkellage manuell mittels einer Durchdrehvorrichtung einzustellen, ist alternativ folgender Ansatz möglich. Hierbei ist der Antriebsstrang als hybridisierter Antriebsstrang ausgeführt, umfassend die als Kurbelwellenstartergenerator ausgeführte Reluktanzmaschine und einen Verbrennungsmotor, wobei die zumindest eine vordefinierte Winkellage des Rotors relativ zum Stator durch eine von mehreren möglichen Ruhepositionen des Verbrennungsmotors oder der Kurbelwelle oder des Schwungrades festgelegt ist, die sich durch eine Auspendelbewegung des Verbrennungsmotors nach einem Motorstopp des Verbrennungsmotors einstellt.

Zur Erläuterung dieser Alternative ist folgendes festzustellen. Die Kurbelwelle oder das Schwungrad eines z. B. Reihensechszylinderverbrennungsmotors nimmt nach Motorstopp durch seine typische Auspendelbewegung immer eine von drei möglichen Ruhepositionen ein. Diese drei typischen Stellungen sind 120° versetzt zueinander. Bei einem Reihenvierzylinderverbrennungsmotor wären es zwei typische Auspendelstellungen. Je nach Bauart des Verbrennungsmotors ergeben sich also immer typische Ruhepositionen nach dem Auspendeln. Damit kann auch ohne definierte manuelle Winkeleinstellung des Rotors zum oberen Totpunkt (OT) des ersten Zylinders die Prüfung der Reluktanzmaschine erfolgen, weil die z. B. drei möglichen bzw. typischen Auspendelstellungen reproduzierbar gleich sind. Wenn man in diesen vorgefundenen Stellungen den Motor gegen Verdrehen vorzugsweise arretiert, könnten gleichfalls Gut-Schlecht-Stossspannungs-Vermessungen durchgeführt werden. Voraussetzungen dieser Alternative wären aber eine Anwachsung im Vorhinein empirisch ermittelter Gut-Antwortkurven als Referenzmesswerte. Diese Alternative bietet somit den besonderen Vorzug, dass die vorherige manuelle Einstellung einer definierten Stellung des Rotors entfallen kann, was einen einfacheren Messablauf ermöglicht.

Alternativ oder zusätzlich kann der zumindest eine vordefinierte Rotorzustand zumindest eine vordefinierte Drehzahl des Rotors umfassen. Der Antriebsstrang kann als hybridisierter Antriebsstrang ausgeführt sein, umfassend die Reluktanzmaschine; vorzugsweise ausgeführt als KSG, und einen Verbrennungsmotor.

Eine mögliche Variante dieser Ausführungsform sieht vor, dass die zumindest eine vordefinierte Drehzahl des Rotors einer Drehzahl unterhalb der Leerlaufdrehzahl entspricht und zur Durchführung der Stoßspannungsprüfung eine Befeuerung des Verbrennungsmotors unterbunden wird. Diese Drehzahl kann mittels einer elektrisch angetriebenen Durchdrehvorrichtung eingestellt werden kann. Die Durchdrehvorrichtung ermöglicht somit eine vordefinierte, geringe Drehzahl, die unterhalb der Leerlaufdrehzahl des Antriebsstrangs durch Betrieb des Verbrennungsmotors liegt und damit im Normalbetrieb nicht erreicht werden kann.

Die Einstellung der vordefinierten Winkellage des Rotors oder der Drehzahl des Rotors unterhalb der Rotordrehzahl kann mittels an sich aus der Praxis bekannter manueller oder elektrischer Durchdrehvorrichtungen erfolgen und damit eine definierte Konjunktion oder Drehgeschwindigkeit der Rotorzähne zum Stator der Reluktanzmaschine erreicht werden.

Eine weitere mögliche Variante dieser Ausführungsform sieht vor, dass die zumindest eine vordefinierte Drehzahl des Rotors mittels eines befeuerten Betriebs des Verbrennungsmotors eingestellt werden kann. Die vordefinierte Drehzahl kann beispielsweise eine Leerlaufdrehzahl des Antriebsstrangs umfassen oder auf die Leerlaufdrehzahl festgelegt sein. Die zumindest eine vordefinierte Drehzahl des Rotors kann als ein vorbestimmter Drehzahlverlauf des Rotors eingestellt werden, vorzugsweise als eine Drehzahlverlaufskurve, wobei während des Durchlaufens des vorbestimmten Drehzahlverlaufs mehrere im Rahmen der Stoßspannungsprüfung erzeugte Schwingungsantworten erfasst und ausgewertet werden können.

Da, wie zuvor erwähnt, bei einer Stoßspannungsprüfung an einer eingebauten Reluktanzmaschine die Streukapazität und die Induktivität zwischen Rotor und Stator, die zu einer Veränderung der erzeugten Schwingungsantwort führen, in starker Abhängigkeit vom Rotorzustand relativ zum Stator variieren, ist es auch möglich, diese Abhängigkeit bei einer gleichmäßigen Drehzahl des Rotors oder bei einem vorbestimmten Drehzahlverlauf vorherzubestimmen, z. B. anhand empirischer Referenzmessung mit Referenz-Reluktanzmaschinen, und entsprechende Vergleichskriterien bereitzustellen. Entsprechend ist anhand der Stoßspannungsprüfung mit einer definierten Bewegung des Rotors während der Messung möglich, einen Defekt der Reluktanzmaschine festzustellen.

Durch das erfindungsgemäße Verfahren kann somit eine elektrische Funktionsprüfung einer Reluktanzmaschine im eingebauten Zustand durchgeführt werden, sodass sowohl in der Bandmontage am Ende der Motorenproduktion als auch im Reklamationsfall eine präzise elektrische Windungsgüteprüfung im eingebauten Zustand und in Serviceniederlassungen durchgeführt werden kann. Der Triebstrang kann so nach einer verlässlichen und protokollierten Diagnose, genannt Gutprüfung, ausgeliefert werden. Bei Schädigungsverdacht eines bestehenden Kraftfahrzeuges muss die Reluktanzmaschine nicht entnommen und zerlegt werden, bevor nicht eine eindeutige Diagnose, genannt Schlechtprüfung, der Windungen erfolgt ist, wobei die Ursache in der Wicklung für die Beanstandung bestätigt werden kann.

Die Vergleichskriterien können sich auf mindestens eine Größe der Schwingungsantworten beziehen und einen erwarteten Wertebereich bzw. eine maximal erlaubte Abweichung zu einem erwarteten Wert angeben. Entspricht die gemessene Größe den Vergleichskriterien, d. h. liegt sie innerhalb des angegebenen Wertebereichs bzw. innerhalb der maximal erlaubten Abweichung, so liegt kein Defekt vor.

Wie zuvor erwähnt, können die Schwingungsantworten einer gedämpften Sinuswelle entsprechen. Entsprechend kann die herangezogene Größe zur Auswertung der Schwingungsantworten anhand der vorbestimmten Vergleichskriterien beispielsweise der Amplitudenverlauf der Schwingungsantwort oder beispielsweise die gemessene Lage eines oder mehrere Nulldurchgänge der erzeugten Schwingungsantwort umfassen. Weitere mögliche Größen der Schwingungsgrößen, die zur Auswertung der Schwingungsantworten anhand der vorbestimmten Vergleichskriterien herangezogen werden können, umfassend die gemessene Schwingungsfrequenz, den gemessenen Dämpfungsgrad, das gemessene Schwingungsmaximum und/oder die gemessene Anstiegszeit nach Beaufschlagung der Stoßspannung.

Die vorstehend beschriebenen statischen Messansätze, d. h. bei denen eine vorbestimmte Winkellage des Rotors zum Stator eingestellt wird, der Rotor sich bei der Stoßspannungsprüfung aber nicht dreht, und dynamischen Messansätze, bei denen der zumindest eine vordefinierte Rotorzustand zumindest eine vordefinierte Drehzahl des Rotors umfasst, mit der sich der Rotor bei der Stoßspannungsprüfung dreht, können auch kombiniert werden, d. h. nacheinander durchgeführt werden, um die Genauigkeit der Windungsgüteprüfung zu verbessern.

Die Vergleichskriterien können auch Kriterien zum Vergleich gemessener Schwingungsantworten untereinander umfassen. Beispielsweise können bei einer dreiphasigen Reluktanzmaschine die Schwingungsantworten aller drei Phasen der Reluktanzmaschine gemessen und miteinander verglichen werden, wobei eine erkennbare Abweichung einer Schwingungsantwort zu den anderen beiden Schwingungsantworten entsprechend der Vergleichskriterien auf ein Defekt hinweist.

Zur erhöhten Genauigkeit des Verfahrens können mehrere Vergleichskriterien herangezogen werden, um festzustellen, ob ein Defekt der Reluktanzmaschine vorliegt oder nicht.

Die Vergleichskriterien können, wie vorstehend bereits erwähnt, anhand von zuvor durchgeführten Referenzmessungen empirisch festgelegt werden, wobei mindestens eine Referenz-Reluktanzmaschine in dem im Kraftfahrzeug eingebauten Zustand bereitgestellt und zur Durchführung der Referenzmessungen der mindestens eine vordefinierte Rotorzustand eingestellt werden kann. Mindestens eine von einem Stoßspannungssignal erzeugte Schwingungsantwort der Referenz-Reluktanzmaschine kann erfasst werden, anhand derer die vorbestimmten Vergleichskriterien festgelegt werden.

Die mindestens eine erzeugte Schwingungsantwort der Referenz-Reluktanzmaschine kann als hinterlegte Referenzmessungen im Rahmen der Stoßspannungsprüfung mit der mindestens einen erzeugten Schwingungsantwort der Reluktanzmaschine anhand der vorbestimmten Vergleichskriterien verglichen werden.

Somit können die Vergleichskriterien durch Referenzmessungen mit Referenz-Reluktanzmaschinen empirisch bestimmt und als Referenzen hinterlegt werden. Dabei ist es möglich, dass aus diesen Referenzmessungen bestimmte Vergleichskriterien, beispielsweise die Lagen der Nulldurchgänge oder die Anstiegszeit nach Beaufschlagung der Stoßspannung, und/oder gesamte Schwingungsantworten der Referenzmessungen hinterlegt werden, um diese mit den gemessenen Schwingungsantworten zu vergleichen.

In einer weiteren Ausführungsform kann das Verfahren jeweils für eine Mehrzahl von Reluktanzmaschinen durchgeführt und die hierbei erzeugte mindestens eine Schwingungsantwort jeweils an einen zentralen Datenspeicher übermittelt werden. Das Verfahren umfasst ferner das Auswerten der in dem zentralen Datenspeicher hinterlegen Schwingungsantworten zur Verbesserung der vorbestimmten Vergleichskriterien.

Dabei können die Stoßspannungsprüfungen von beliebigen im Feld verteilten Messeinrichtungen durchgeführt und die erzeugten Schwingungsantworten dann an die zentrale Datenablage übertragen werden, wo Vergleichskriterien anhand der gesammelten Schwingungsantworten bestimmt und den im Feld verteilten Messeinrichtungen bereitgestellt werden können.

Durch die immer höhere Statistik an gesammelten Schwingungsantworten können so immer präzisere Vergleichskriterien bereitgestellt werden. Das Verfahren kann somit nach jeder Messung seine Genauigkeit, einen Defekt der Reluktanzmaschine festzustellen, erhöhen.

Die mindestens eine bereitgestellte Referenz-Reluktanzmaschine kann eine erste Referenz-Reluktanzmaschine im nicht-defekten Zustand sein. Alternativ oder zusätzlich kann die mindestens eine bereitgestellte Referenz-Reluktanzmaschine eine zweite Referenz-Reluktanzmaschine im defekten Zustand, oder mehrere zweite Referenz-Reluktanzmaschinen im defekten Zustand umfassen, wobei die mehreren zweiten Referenz-Reluktanzmaschinen unterschiedliche bekannte Defektzustände aufweisen.

Dadurch ist es möglich, anhand der Vergleichskriterien nicht nur zu bestimmen, ob ein Defekt vorliegt, sondern auch, um welche Art von Defekt es sich handelt. Dadurch ist eine schnelle und zielführende Reparatur der defekten Reluktanzmaschine möglich.

Es kann eine zweite Referenz-Reluktanzmaschine mit einem Kurzschluss in einer der Wicklungen vorliegen. Eine weitere zweite Referenz-Reluktanzmaschine kann eine Deformation, Lageänderung und/oder Korrosion einer Windung vorweisen.

Die Vergleichskriterien können auch durch anderweitige Erfahrungswerte und/oder durch Computersimulationen bestimmt werden.

Die Auswertung der gemessenen Schwingungsantworten mit den Vergleichskriterien kann mittels Softwarealgorithmen und/oder manueller Beurteilungskriterien erfolgen und damit eine Aussage darüber getroffen werden, ob ein Defekt vorliegt oder nicht.

Defekte können Beschädigungen der Windungen sein. Diese Beschädigungen können zu einem Abfall der gemessenen Induktivität und damit zu einer Veränderung der Schwingungsantwort führen. Defekte können sowohl Kurzschlüsse in den Wicklungen, beispielsweise hochtemperaturlackisolierte Wicklungen, als auch Deformationen, Lageänderungen und/oder Korrosion der Windungen sein.

Vorstehend wurde bereits festgestellt, dass die Reluktanzmaschine ein Kurbelwellenstartergenerator sein kann. Alternativ oder zusätzlich kann die Reluktanzmaschine zur Durchführung der Stoßspannungsprüfung von einem Inverter getrennt sein. Der Inverter, auch Wechselrichter genannt, stellt den erforderlichen Mehrphasen-Wechselstrom aus den im Kraftfahrzeug üblicherweise vorhandenen Gleichstromquellen bereit. Die Trennung des Inverters dient dazu, dass die zu prüfende Wicklung des Stators bei der Stoßspannungsprüfung ausschließlich durch die Stoßspannung beaufschlagt ist und keinen weiteren Strom führt, der die Messergebnisse der Prüfung verfälschen könnte.

Bei dem Kurbelwellenstartergenerator können die Wicklungen, die beispielsweise aus Kupfer bestehen, eine geringe Windungszahl und einen hohen Querschnitt aufweisen. Dadurch können die Wicklungen im Niedervoltbereich zur Leistungsumsetzung hohe elektrische Ströme führen. Entsprechend können diese Wicklungen nur sehr geringe Induktionswerte aufweisen, wodurch sich Induktionsunterschiede, unter anderem bei einem Kurzschluss, nur in eben diesen geringen Induktivitätsbereichen bewegen. Durch Einstellen eines vorbestimmten Rotorzustandes relativ zum Stator wie vorstehend beschrieben, ist es jedoch möglich, diese kleinen Induktionsunterschiede bei einer defekten vs. nicht defekten Reluktanzmaschine im Rahmen einer Stoßspannungsprüfung zuverlässig zu erkennen, in dem Vergleichskriterien, wie vorstehend beschrieben, z. B. basierend auf der Lage der Nullpunktdurchgänge der Schwingungsantwort, gewählt werden.

Gemäß einer weiteren Ausführungsform kann das Verfahren ein Erfassen eines aktuellen Werts mindestens eines Parameters, der die im Rahmen der Stoßspannungsprüfung erzeugte Schwingungsantwort beeinflusst, umfassen. Der aktuelle Wert des Parameters kann in die Auswertung eingehen, um festzustellen, ob ein Defekt der Reluktanzmaschine vorliegt oder nicht. Damit können mögliche Defekte der Reluktanzmaschine noch besser erkannt werden, dadurch dass die Spannungsantwort beeinflussende Parameter entsprechend herausgerechnet oder anderweitig berücksichtigt werden können.

Dieser mindestens eine Parameter kann einen Umgebungsparameter umfassen, beispielsweise eine Temperatur oder eine Luftfeuchtigkeit. Alternativ oder zusätzlich kann der mindestens eine Parameter mindestens einen die Reluktanzmaschine charakterisierenden Maschinenparameter umfassen. Dieser mindestens eine Maschinenparameter kann ein Alter, eine Laufzeit, eine Bauart, und/oder eine Kalibrierinformation der Reluktanzmaschine umfassen.

In den vorbestimmten Vergleichskriterien können damit systematische Einflüsse entsprechend der Umgebungs- und/oder Maschinenparameter berücksichtigt werden. So können unter anderem Vergleichskriterien für verschiedene Umgebungs- und/oder Maschinenparameter vorliegen, sodass die entsprechenden Vergleichskriterien für den erfassten Parameter ausgewählt und für die Auswertung herangezogen werden können. Beispielsweise können so Vergleichskriterien sowohl für eine Reluktanzmaschine im Neuzustand als auch im gebraucht relaxierten Gut-Zustand bereitgestellt werden.

Somit können weitere Einflüsse auf die Form der Schwingungsantworten berücksichtigt und als Ursachen für mögliche Abweichungen eliminiert oder erkannt werden, sodass durch die Stoßspannungsprüfungen noch genauere Aussagen getroffen werden können, ob ein Defekt der Reluktanzmaschine vorliegt oder nicht.

Die Temperatur kann beispielsweise über einen Temperatursensor der Messeinrichtung direkt erfasst werden. Die Luftfeuchtigkeit kann durch einen externen, der Messeinrichtung zuzuordnenden Sensor und/oder durch einen Luftfeuchtigkeitssensor, der im Kraftfahrzeug verbaut ist, erfasst werden. Der vorstehend genannte, mindestens eine Maschinenparamater, wie beispielsweise das Alter, die Laufzeit, eine Bauart und/oder eine Kalibrierinformation der Reluktanzmaschine, kann über standardisierte Schnittstellen aus einem Datenpool des Kraftfahrzeuges ausgelesen werden.

Eine weitere Möglichkeit, systematische Einflüsse einzuschränken, ist beispielsweise, die Stoßspannungsprüfungen des Verfahrens immer bei der gleichen, konstanten Umgebungstemperatur oder ein einem vorbestimmten Umgebungstemperaturbereich durchzuführen.

Eine weitere Möglichkeit, systematische Einflüsse einzuschränken, ist beispielsweise, die Stoßspannungsprüfungen des Verfahrens immer bei einem vorbestimmten Umgebungsluftfeuchtigkeitsbereich und/oder bei einem vorbestimmten Feuchtegehalt der Wicklungen des Stators durchzuführen. Der Feuchtegehalt (Zwischenraumwasser, Tropfwasser, etc.) der Wicklungen des Stators kann die Schwingungsantwort beeinflussen. Der Prüfling, d. h. die zu prüfende Reluktanzmaschine, sollte keine zu hohe Feuchte aufweisen. In diesem Fall ist die Reluktanzmaschine vorzugsweise vor den Messungen zu trocknen oder zu konditionieren. Dies kann beispielsweise dadurch erfolgen, dass der Verbrennungsmotor für eine kurze Zeitdauer befeuert wird, so dass die entstehende Wärme zu einer Trocknung führt.

Der aktuelle Wert des Parameters kann derart in die Auswertung eingehen, dass aus einer Menge zuvor hinterlegter Referenzmesswerte oder Referenz-Schwingungsantworten eine Teilmenge ausgewählt wird, die einer Referenzmessung mit dem aktuellen Wert des Parameters entspricht oder zumindest näherungsweise entspricht. Alternativ oder zusätzlich kann dieser aktuelle Wert des Parameters zur Auswertung anhand der vorbestimmten Vergleichskriterien der erzeugten Schwingungsantwort der Reluktanzmaschine verwendet werden.

Es können beispielsweise Referenzmessungen mit Referenz-Reluktanzmaschinen bei verschiedenen Umgebungstemperaturen durchgeführt und als Referenzmesswerte hinterlegt werden. Die Vergleichskriterien für verschiedene Parameter können auch durch anderweitige Erfahrungswerte und/oder durch Computersimulationen bestimmt werden.

Die zuvor beschriebenen bevorzugten Ausführungsformen und Merkmale der Erfindung sind beliebig miteinander kombinierbar. Weitere Einzelheiten und Vorteile der Erfindung werden im Folgenden unter Bezug auf die beigefügten Zeichnungen beschrieben. Es zeigen:
Figur 1 eine grafische Darstellung der Schwingungsantworten in der nicht-defekten ersten, zweiten und dritten Phase des Stators bei einer Stoßspannungsprüfung ohne eingebauten Rotor, gemäß dem Stand der Technik;
Figur 2 eine grafische Darstellung der Schwingungsantworten in der defekten ersten Phase und der nicht-defekten zweiten und dritten Phase des Stators bei einer Stoßspannungsprüfung ohne eingebauten Rotor, gemäß dem Stand der Technik;
Figur 3 eine grafische Darstellung der Schwingungsantworten in der nicht-defekten ersten, zweiten und dritten Phase des Stators bei einer Stoßspannungsprüfung mit eingebautem Rotor im Stillstand;
Figur 4 eine grafische Darstellung der Schwingungsantworten in der defekten ersten Phase und der nicht-defekten zweiten und dritten Phase des Stators bei einer Stoßspannungsprüfung mit eingebautem Rotor im Stillstand;
Figur 5 eine grafische Darstellung der Schwingungsantworten in der nicht-defekten ersten, zweiten und dritten Phase des Stators bei einer Stoßspannungsprüfung mit rotierendem, eingebautem Rotor;
Figur 6 eine grafische Darstellung der Schwingungsantworten in der defekten ersten Phase und der nicht-defekten zweiten und dritten Phase des Stators bei einer Stoßspannungsprüfung mit rotierendem, eingebautem Rotor;
Figur 7 ein Verfahren zur elektrischen Funktionsprüfung, vorzugsweise zur Windungsgüteprüfung, einer elektrischen Reluktanzmaschine eines Kraftfahrzeugs;
Figur 8 ein schematisches Blockdiagramm zur Illustration eines Antriebsstrangs mit einer Reluktanzmaschine, ausgeführt als KSG;
Figur 9 einen Querschnitt eines Antriebsstrangmoduls mit einer Reluktanzmaschine ausgeführt als Kurbelwellenstartergenerator, und
Figur 10 eine stark schematisierte Darstellung einer vorbestimmten Winkellage des Rotors relativ zum Stator gemäß einer Ausführungsform.

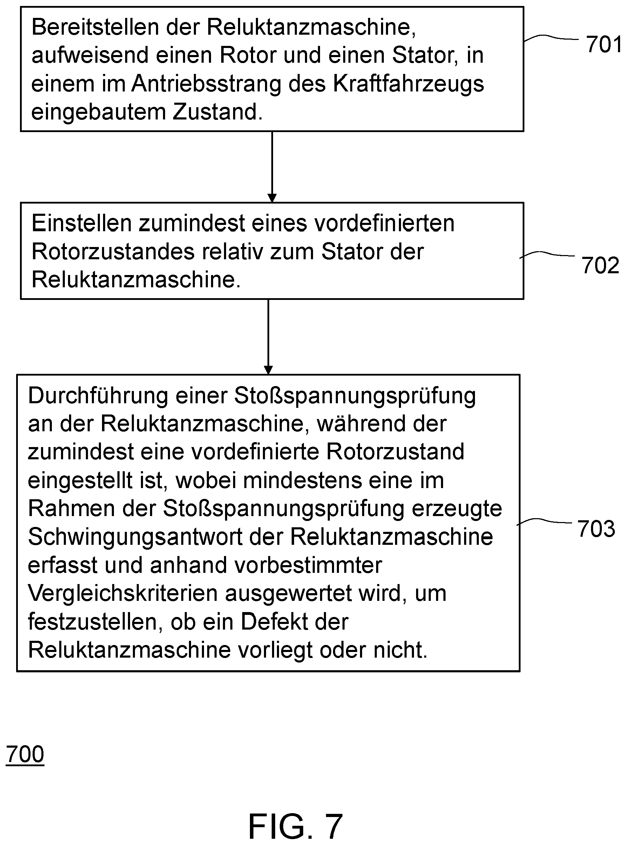

Figur 7 zeigt ein Ausführungsbeispiel eines allgemein mit Bezugszeichen 700 bezeichneten Verfahrens zur elektrischen Funktionsprüfung, vorzugsweise zur Windungsgüteprüfung, einer elektrischen Reluktanzmaschine eines Kraftfahrzeugs.

Gleiche oder äquivalente Elemente sind in allen Figuren mit gleichen Bezugszeichen versehen und zum Teil nicht gesondert beschrieben.

Das Verfahren 700 umfasst das Bereitstellen der Reluktanzmaschine, aufweisend einen Rotor und einen Stator, in einem im Antriebsstrang des Kraftfahrzeugs eingebautem Zustand (Schritt 701). Ferner umfasst das Verfahren 700 das Einstellen zumindest eines vordefinierten Rotorzustandes relativ zum Stator der Reluktanzmaschine (Schritt 702). Zudem umfasst das Verfahren 700 die Durchführung einer Stoßspannungsprüfung an der Reluktanzmaschine, während der zumindest eine vordefinierte Rotorzustand eingestellt ist, wobei mindestens eine im Rahmen der Stoßspannungsprüfung erzeugte Schwingungsantwort der Reluktanzmaschine erfasst und anhand vorbestimmter Vergleichskriterien ausgewertet wird, um festzustellen, ob ein Defekt der Reluktanzmaschine vorliegt oder nicht (Schritt 703).

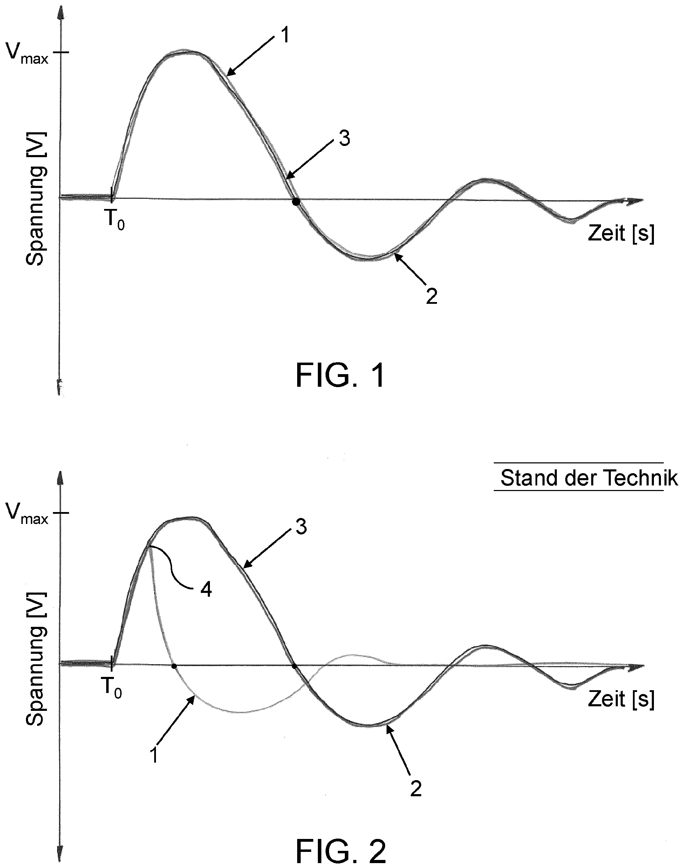

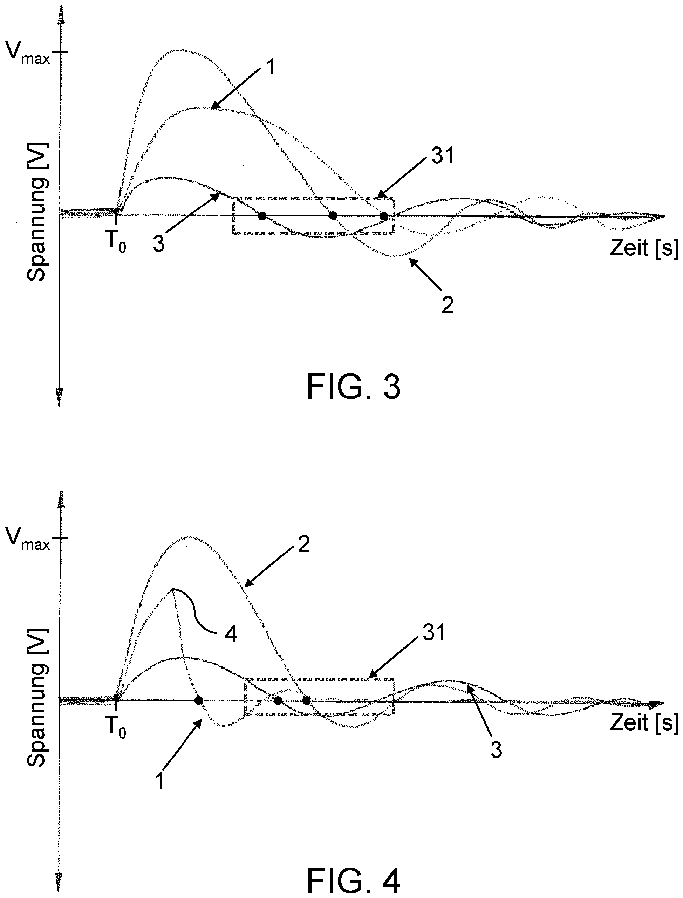

Im Folgenden werden gemessene Schwingungsantworten für Stoßspannungsprüfungen an einer dreiphasigen Reluktanzmaschine gezeigt und diskutiert. Die Figuren 1 bis 6 zeigen jeweils die Schwingungsantwort für eine Stoßspannungsprüfung an der ersten, zweiten und dritten Phase des Stators, bezeichnet jeweils mit den Referenzzeichen 1, 2 und 3 entsprechend der geprüften Phase. Die Schwingungsantworten sind jeweils als Funktion der gemessenen Spannung in Abhängigkeit von der Zeit aufgetragen, wobei die jeweilige Phase zum Zeitpunkt T₀ mit einer Stoßspannung beaufschlagt worden sind. Dabei zeigen die Figuren 1 und 2 zunächst beispielhaft die gemessenen Schwingungsantworten einer Stoßspannungsprüfung nach dem Stand der Technik. Die Figuren 3 bis 6 zeigen beispielhafte Schwingungsantworten, die entsprechend Schritt 703 bei der Durchführung der Stoßspannungsprüfung erzeugt werden.

Die Figuren 1 und 2 zeigen zunächst beispielhaft die gemessenen Schwingungsantworten einer Stoßspannungsprüfung nach dem Stand der Technik.

Figur 1 zeigt eine grafische Darstellung der Schwingungsantworten in der nicht-defekten ersten, zweiten und dritten Phase des Stators bei einer Stoßspannungsprüfung ohne eingebauten Rotor, gemäß dem Stand der Technik.

Die Schwingungsantworten zeigen die Verläufe gedämmter Sinuswellen, die bei der Beaufschlagung der Stoßspannung zum Zeitpunkt T₀ beginnen und mit zunehmender Zeit gedämpft werden. Dabei zeigen alle drei Schwingungsantworten einen fast identischen Verlauf.

Figur 2 zeigt eine grafische Darstellung der Schwingungsantworten in der defekten ersten Phase und der nicht-defekten zweiten und dritten Phase des Stators bei einer Stoßspannungsprüfung ohne eingebauten Rotor, gemäß dem Stand der Technik.

Allein durch optischen Vergleich der drei Schwingungsantworten ist hier eine klare Abweichung der Schwingungsantwort 1 der ersten Phase erkennbar. So ist die Anstiegszeit nach T₀ für die Schwingungsantwort 1 der ersten Phase wesentlich kürzer ist als für die anderen Schwingungsantworten 2, 3. Zudem wird ein wesentlich geringeres Maximum und ein wesentlich größerer Dämpfungsgrad erreicht als bei den anderen beiden Schwingungsantworten 2, 3 der defektenfreien Phasen. Ein spitzförmiger Abbruch 4 des Spannungsanstiegs zeigt den Durchbruch der Spannung, z. B. aufgrund eines Windungskurzschlusses, auf.

Die Figuren 3 und 4 zeigen beispielhaft die gemessenen Schwingungsantworten einer Stoßspannungsprüfung mit einem eingebauten Rotor im Stillstand. Die Reluktanzmaschine befindet sich dabei in einem im Antriebsstrang des Kraftfahrzeugs eingebautem Zustand.

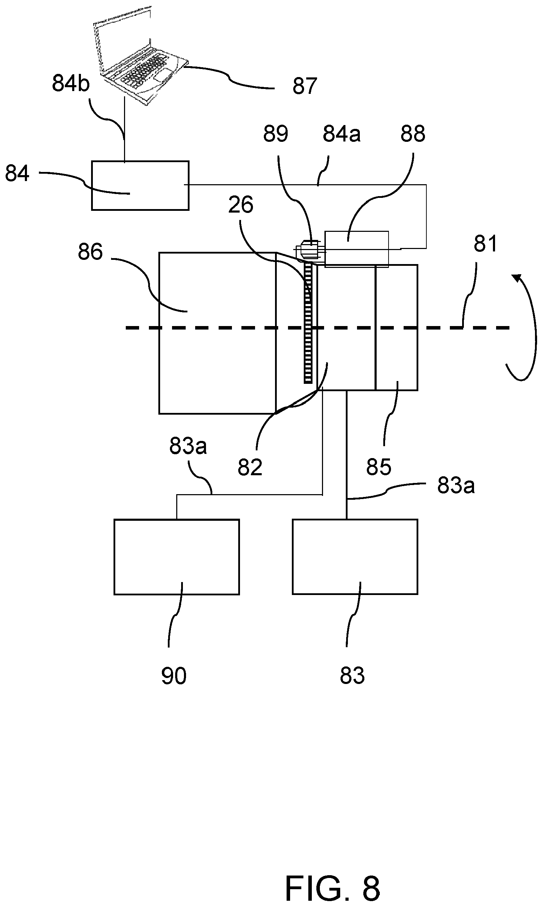

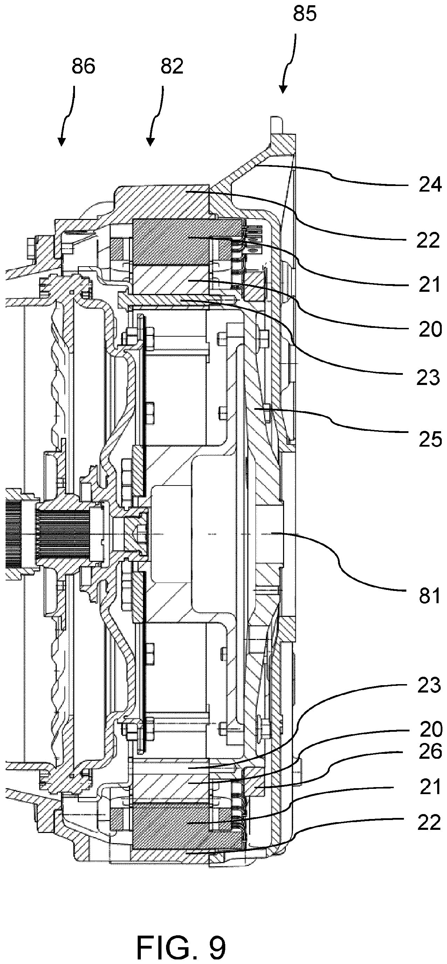

Ein Verfahren zur elektrischen Funktionsprüfung einer elektrischen Reluktanzmaschine eines Kraftfahrzeugs gemäß der Erfindung, wobei die sich der eingebaute Rotor während der Prüfung im Stillstand befindet, kann beispielsweise wie folgt durchgeführt werden. Die Reluktanzmaschine ist als KSG ausgeführt, der in an sich bekannter Weise im Antriebsstrang zwischen Verbrennungsmotor und Getriebe am Schwungradgehäuse oder im Schwungradgehäuse eingebaut ist. Eine beispielhafte Ausführung einer solchen Reluktanzmaschine und eines Antriebstrangs ist weiter untenstehend anhand der Figuren 8 und 9 erläutert.

Der KSG wird auf Defekte überprüft. Das KSG kann drei Phasen mit je zehn Spulen, die nacheinander am Außenumfang des Stators angeordnet sein können, aufweisen. Die drei Phasen können außen zweipolig getrennt zugänglich sein. Zudem kann der KSG vom Inverter abgetrennt sein. Ein an sich bekanntes Stoßspannungsmessgerät kann entweder mit dem Kraftfahrzeug verlinkt sein und dadurch Stützinformationen (Temperaturen, Feuchte, weitere Daten) erhalten oder vorprogrammierte Prüflingsdaten des KSG beinhalten. Zur Durchführung der Stoßspannungsprüfung ist das Stoßspannungsmessgerät über einen Messaufnehmer galvanisch jeweils an den einzelnen Phasen und einer Masse angeschlossen.

Des Weiteren befindet sich der Triebstrang im Stillstand. Die Lage des Rotors relativ zum Stator wird mittels einer Durchdrehvorrichtung oder wie nachfolgend in Zusammenhang mit den Figuren 8 und 9 beschrieben in eine vordefinierte Winkelposition relativ zum Stator gebracht und anschließend gegen Verdrehung blockiert. Anschließend wird eine Folge von Stoßspannungsprüfungen durch die Einzelphasen durchgeführt. Zur Auswertung kann ein messgeräteinterner und optischer Vergleich der Schwingungsantworten gegenüber den zu erwartenden Schwingungsantworten stattfinden. Durch Vergleich der Messwerte gegen vordefinierte Vergleichskriterien mittels Softwarealgorithmen und/oder manueller Beurteilungskriterien kann eine Gut/Schlecht-Aussage getroffen werden, d. h. ein Windungsdefekt in mindestens einer der drei Phasen festgestellt werden.

Alternativ kann die Lage des Rotors relativ zum Stator mittels Durchdrehvorrichtung oder wie nachfolgend in Zusammenhang mit den Figuren 8 und 9 beschriebenen Einstellung einer Rotordrehlage in drei nacheinander vordefinierte Winkelpositionen gebracht und jeweils für die Einzelmessung kurzzeitig fixiert werden. Jede Phase wird mittels einer Folge von Stoßspannungsentladungen vermessen, wobei die Rotorzähne jeweils in vergleichbarer Konjunktion zum Stator auch vergleichbare Antwortwellen erzeugen können. Die vordefinierten Vergleichskriterien werden mit den Antwortwellen verglichen, so dass eine Gütebewertung der Windungen durchgeführt werden kann. Im Fehlerfall kann eine abweichende Phase direkt bestimmt werden.

Figur 3 zeigt eine grafische Darstellung der Schwingungsantworten in der nicht-defekten ersten, zweiten und dritten Phase des Stators bei einer Stoßspannungsprüfung mit eingebautem Rotor im Stillstand.

Hier ist der Einfluss durch den eingebauten Rotor zu erkennen, da die Schwingungsantworten der drei Phasen, im Gegensatz zu den Schwingungsantworten in Figur 1, keinen im wesentlich identischen Verlauf zeigen. So erreichen alle drei Schwingungsraten erkennbar unterschiedliche Maxima und zeigen unterschiedliche Schwingungsfrequenzen bzw. Abklingkurven.

Figur 4 zeigt eine grafische Darstellung der Schwingungsantworten in der defekten ersten Phase und der nicht-defekten zweiten und dritten Phase des Stators bei einer Stoßspannungsprüfung mit eingebautem Rotor im Stillstand.

Im Vergleich zu der in Figur 3 dargestellten Schwingungsantwort 1 der ersten Phase zeigt die entsprechende Schwingungsantwort 1 der ersten Phase in Figur 4 erkennbare Abweichungen. So zeigt die Schwingungsantwort 1 in Figur 4 einen schlagartigen Abfall 4, resultierend in einer wesentlich kürzeren Anstiegszeit nach T₀ für die Schwingungsantwort 1 und einem wesentlich größeren Dämpfungsgrad als die Schwingungsantwort 1 in Figur 3.

Beispielhaft kann das vorbestimmte Vergleichskriterium 31 einem Zeitfenster entsprechen, indem die ersten Nulldurchgänge der Schwingungsantworten liegen müssen, damit kein Defekt der Reluktanzmaschine festgestellt wird. Wie in Figur 3 zu erkennen ist, liegen alle Nulldurchgänge der Schwingungsantworten 1, 2, 3 innerhalb des Zeitfensters. In Figur 4 ist dies jedoch nur für die Schwingungsantworten 2, 3 der zweiten und dritten Phase der Fall, während der erste Nulldurchgang der Schwingungsantwort 1 der ersten Phase in Figur 4 wesentlich früher erfolgt und damit das Vergleichskriterium 31 nicht erfüllt ist. Nach Auswertung entsprechend diesem Vergleichskriterium 31 wird daher ein Defekt der geprüften ersten Phase festgestellt.

Vorstehend wurde bereits festgestellt, dass ein alternativer Messansatz darin besteht, die Stoßspannungsprüfung bei einer vordefinierten Winkellage des Rotors relativ zum Stator durchzuführen, die sich durch eine Auspendelbewegung des Verbrennungsmotors nach einem Motorstopp des Verbrennungsmotors einstellt, so dass diese vordefinierte Winkellage des Rotors nicht manuell mittels einer Durchdrehvorrichtung eingestellt werden muss. Die Antwortkurven entsprächen auch bei diesem Messansatz prinzipiell denen der Figuren 3 und 4.

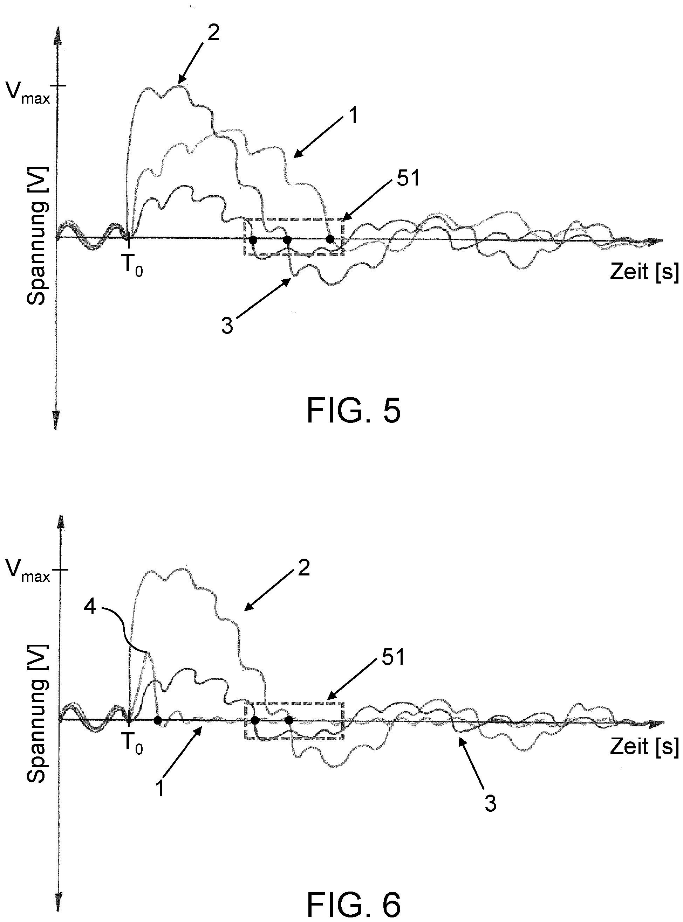

Die Figuren 5 und 6 zeigen beispielhaft die gemessenen Schwingungsantworten einer Stoßspannungsprüfung mit einem eingebauten Rotor in Rotation.

Ein Verfahren zur elektrischen Funktionsprüfung einer elektrischen Reluktanzmaschine eines Kraftfahrzeugs gemäß der Erfindung, wobei die sich der eingebaute Rotor während der Prüfung in Rotation befindet, kann beispielsweise wie folgt durchgeführt werden.

Wie zuvor wird ein Kurbelwellenstartergenerator (KSG) auf Defekte überprüft. Das KSG kann drei Phasen mit je zehn Spulen, die nacheinander am Außenumfang des Stators angeordnet sein können, aufweisen. Die drei Phasen können außen zweipolig getrennt zugänglich sein. Zudem kann der KSG vom Inverter abgetrennt sein. Ein Stoßspannungsmessgerät kann entweder mit dem Kraftfahrzeug verlinkt sein und dadurch Stützinformationen (Temperaturen, Feuchte, weitere Daten) erhalten oder vorprogrammierte Prüflingsdaten des KSG beinhalten. Zur Durchführung der Stoßspannungsprüfung ist das Stoßspannungsmessgerät über einen Messaufnehmer galvanisch jeweils an den einzelnen Phasen und einer Masse angeschlossen.

Der Triebstrang wird mittels elektrischer Durchdrehvorrichtung, z. B. ausgeführt als herkömmlicher elektrischer Startermotor, in Rotation mit definierter niedriger Drehzahl, beispielsweise 180 U/min, gebracht. Die Befeuerung des Verbrennungsmotors wird unterbunden. Eine Folge von Stoßspannungsprüfungen durch die Einzelphasen wird in dieser definierten dynamischen Situation durchgeführt. Die auf Grund des Induktionsgesetzes erhaltenen elektrischen Signale werden ausgewertet. Es kann ein messgeräteinterner und/oder optischer Vergleich der Schwingungsantwort gegenüber den zu erwartenden Abklingkurven der Entladungsenergie des Messgerätekondensators und der durch die Induktion erfolgte überlagerte Sinuswelle stattfinden. Dabei werden die quasichaotischen Antwortwellenformen - verursacht durch den sich drehenden Rotor und der spezifischen Drehungleichförmigkeit mit der Folge von drehzahlsynchron ausgeglichenen Streuwerten der Phasen untereinander - gegen vordefinierte Vergleichskriterien verglichen. Eine Gut/Schlecht-Aussage kann damit getroffen werden.

Alternativ kann der Triebstrang mittels des Verbrennungsmotors in Rotation mit z. B. Leerlaufdrehzahl, beispielsweise 600 U/min, oder einer für den End-Of-Line-Kalttest geeigneten Drehzahlverlaufskurve beaufschlagt werden. Eine Folge von Stoßspannungsprüfungen durch die Einzelphasen wird in dieser definierten dynamischen Situation durchgeführt. Die auf Grund des Induktionsgesetzes erhaltenen elektrischen Signale werden ausgewertet. Es kann ein messgeräteinterner und/oder optischer Vergleich der Schwingungsantwort gegenüber den zu erwartenden Abklingkurven der Entladungsenergie des Messgerätekondensators und der durch die Induktion erfolgte überlagerte Sinuswelle des generatorischen Zustandes stattfinden. Dabei werden die quasichaotischen Antwortwellenformen - verursacht durch den sich drehenden Rotor und der spezifischen Drehungleichförmigkeit mit der Folge von drehzahlsynchron ausgeglichenen Streuwerten der Phasen untereinander - gegen vordefinierte Vergleichskriterien und mit Hilfe geeigneter Softwareauswertealgorithmen verglichen. Eine Gut/Schlecht-Aussage über den Zustand der Windungen kann damit getroffen werden.

Figur 5 zeigt eine grafische Darstellung der Schwingungsantworten in der nicht-defekten ersten, zweiten und dritten Phase des Stators bei einer Stoßspannungsprüfung mit rotierendem, eingebautem Rotor.

Hier ist wiederum der Einfluss durch den eingebauten Rotor zu erkennen, wobei die Rotation des Rotors dazu führt, dass die Schwingungsantworten keinen gleichmäßigen Verlauf einer gedämpften Sinuswelle zeigen, sondern zusätzlich einen wellenförmigen Charakter innerhalb der einzelnen Schwingungsperioden. Es ist insbesondere zu erkennen, dass bereits vor Beaufschlagung der Stoßspannung zum Zeitpunkt T₀ eine Spannung in den einzelnen Phasen gemessen werden kann. Es kommt zur Überlagerung zwischen einer Abklingkurve und einer stetigen Schwingungsantwort.

Figur 6 zeigt eine grafische Darstellung der Schwingungsantworten in der defekten ersten Phase und der nicht-defekten zweiten und dritten Phase des Stators bei einer Stoßspannungsprüfung mit rotierendem, eingebautem Rotor.

Im Vergleich zu der in Figur 5 dargestellten Schwingungsantwort 1 der ersten Phase zeigt die entsprechende Schwingungsantwort 1 der ersten Phase in Figur 6 erkennbare Abweichungen. So zeigt die Schwingungsantwort 1 in Figur 6 einen schlagartigen Abfall 4 und einem weiteren Schwingungsverlauf nahe 0, resultierend in einer wesentlich kürzeren Anstiegszeit nach T₀ für die Schwingungsantwort 1 und einem wesentlich größeren Dämpfungsgrad als die Schwingungsantwort 1 in Figur 5.

Beispielhaft kann das vorbestimmte Vergleichskriterium 51 einem Zeitfenster entsprechen, indem die ersten Nulldurchgänge der Schwingungsantworten liegen müssen, damit kein Defekt festgestellt wird. Wie in Figur 5 zu erkennen ist, liegen alle Nulldurchgänge der Schwingungsantworten 1, 2, 3 innerhalb des Zeitfensters. In Figur 6 ist dies jedoch nur für die Schwingungsantworten 2, 3 der zweiten und dritten Phase der Fall, während der erste Nulldurchgang der Schwingungsantwort 1 der ersten Phase in Figur 6 wesentlich früher erfolgt und damit das Vergleichskriterium 51 nicht erfüllt ist. Nach Auswertung entsprechend diesem Vergleichskriterium 51 wird daher ein Defekt der geprüften ersten Phase festgestellt.

Die Figuren 8 und 9 zeigen lediglich beispielhaft einen Antriebsstrang eines Nutzfahrzeugs mit einer eingebauten Reluktanzmaschine, die als KSG ausgeführt ist. Es wird betont, dass dies nur eine beispielhafte Ausführungsform ist und das erfindungsgemäße Verfahren auch auf andere Reluktanzmaschinen und Antriebsstrangkonfigurationen anwendbar ist.

Figur 8 zeigt ein schematisches Blockdiagramm zur Illustration einer Ausführungsform des Antriebsstrangs. Eine Reluktanzmaschine, ausgeführt als elektrischer Kurbelwellenstartergenerator (KSG) 82 ist zwischen einem Getriebe 86 und einer Schwungradvorrichtung 85 einer Brennkraftmaschine koaxial zur Kurbelwelle 81 vorgesehen. In Figur 8 ist die Kurbelwelle durch die gestrichelte Linie schematisch dargestellt, die die Mittelachse der Kurbelwelle darstellen soll. Der Rotor des KSGs 82 ist drehfest mit dem Schwungrad der Schwungradvorrichtung 85 verbunden, welches wiederum drehfest mit der Kurbelwelle 81 verbunden ist. Derartige Antriebsstranganordnungen sind an sich aus dem Stand der Technik bekannt. In Figur 9 ist lediglich eine mögliche Variante der konstruktiven Ausgestaltung beispielhaft dargestellt, wobei nachfolgend nur die relevantesten Komponenten kurz erläutert werden. Die Schwungradvorrichtung 85 umfasst ein Schwungrad 25 und ein das Schwungrad 25 motorseitig abdeckendes Schwungradgehäuse 24. Gemäß der in Figur 9 gezeigten Ausführungsvariante ist der Rotor 20 ausschließlich mittels Schrauben 23 am Schwungrad 25 befestigt, so dass das Schwungrad 25 und der Rotor 20 bewegungsgekoppelt sind. Gemäß einer weiteren, nicht gezeigten Variante kann der Rotor 20 auch auf eine Zylindermantelfläche aufgebracht (Passsitz) werden, die am Schwungrad 25 angeformt ist und sich in Axialrichtung der Kurbelwelle 81 erstreckt. Der KSG-Stator 21 ist starr an einem KSG-Gehäuse 22 gehaltert und konzentrisch zum Rotor 20 angeordnet. Das KSG-Gehäuse 22 ist mit dem Schwungradgehäuse 24 verschraubt und zumindest teilweise in diesem verbaut. Abtriebsseitig ist ein Getriebe 86 über flexible Adapterplatten, sog. Flex-Platten, am Rotor 20 befestigt. Ferner ist ein Zahnkranz 26 vorgesehen, welcher zum Kaltstart von einem Startmotor 88 angerieben werden kann. Es wird nochmals betont, dass der konstruktive Aufbau in Figur 9 lediglich beispielhaft ist und andere aus dem Stand der Technik bekannte konstruktive Ausgestaltungen eines Antriebsstrangmoduls mit einem KSG ebenfalls verwendet werden können. Wie in Figur 8 dargestellt, wird der Betrieb des KSGs 82 von einem Inverter 83 gesteuert, der den KSG 82 beispielsweise in an sich bekannter Weise bestromt, um einen Warm-Startvorgang der Brennkraftmaschine durchzuführen.

Für einen Kaltstart des Verbrennungsmotors ist jedoch ein herkömmlicher elektrischer Startermotor 88 vorgesehen, der ein Ritzel 89 antreibt, dass mit dem Zahnkranz 26 kämmt. Um einen Kaltstart durchzuführen, steuert das Motorsteuergerät (ECU) 84 den Startermotor 88 über eine elektrische Signalleitung 84a an. Der KSG 82 wird für Warmstarts verwendet.

Um das vorstehend beschriebene Verfahren 700 zur elektrischen Windungsgüteprüfung der elektrischen Reluktanzmaschine (des KSGs) 82 durchzuführen, kann der Startermotor 88 als elektrische Durchdrehvorrichtung verwendet werden, um einen vordefinierten Rotorzustand relativ zum Stator der Reluktanzmaschine (KSG), hier das elektrische Durchdrehen, zu erzeugen. Vorstehend wurde bereits festgestellt, dass das Einstellen (Schritt 702) zumindest eines vordefinierten Rotorzustandes relativ zum Stator der Reluktanzmaschine dadurch erfolgen kann, dass zumindest eine vordefinierte Drehzahl des Rotors eingestellt wird.

Hierbei wird ein Service-Laptop 87 über eine Datenleitung (elektrische Signalleitung) 84b in Kommunikationsverbindung mit dem Motorsteuergerät 84 gebracht. Hierzu kann beispielsweise der Startermotor 88 über den Service-Laptop 87 und das Motorsteuergerät (ECU) 84 angesteuert werden, z. B. derart, dass dieser sich mit einer vorbestimmten Drehzahl dreht, z. B. 180 U/min, bei abgeschalteter Einspritzung. Hierbei ist der KSG 82 von seinem Inverter 83 abgeklemmt. Stattdessen wird über die elektrischen Leitungen 83, über die normalerweise der Inverter 83 an den KSG 92 angeschlossen wird, ein Wicklungsprüfgerät 90 an den Stator des KSG 92 angeschlossen, um die Stoßspannungsprüfung durchzuführen.

Vorstehend wurde bereits ferner festgestellt, dass das Einstellen (Schritt 702) zumindest eines vordefinierten Rotorzustandes relativ zum Stator der Reluktanzmaschine alternativ dadurch erfolgen kann, dass zumindest eine vordefinierte Winkellage des Rotors relativ zum Stator eingestellt wird und der KSG 82 sich im Stillstand befindet. Dies kann mittels einer an sich bekannten manuellen Durchdrehvorrichtung und einer Winkelskala durchgeführt werden.

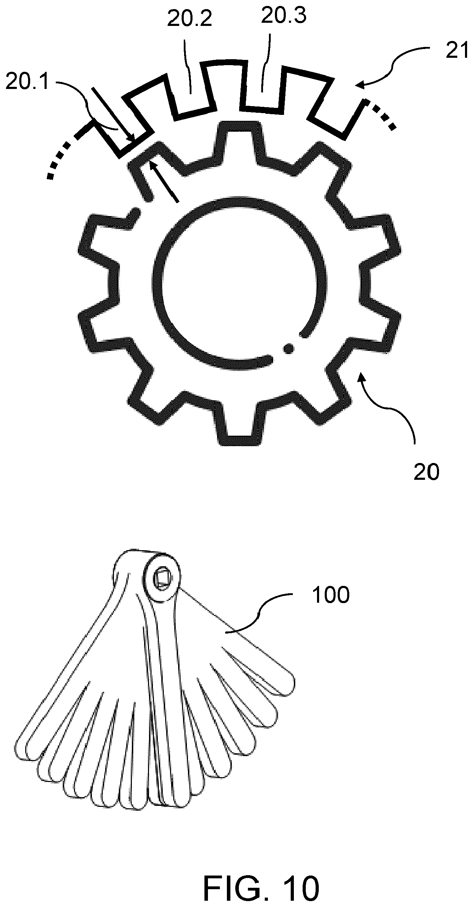

Dies ist lediglich beispielhaft in Figur 10 schematisch illustriert. Hierbei wird mittels der manuellen Durchdrehvorrichtung und einer Winkelskala, die beispielsweise auf dem Schwungrad angebracht sein kann, eine definierte Position zwischen Rotor 20 und Stator 21 eingestellt und arretiert, z. B. mit einer Positionsarretierung, so dass sich ein Zahn des Rotors 20 in Konjunktion mit einer vorbestimmten Phase des Stators befindet. In Figur 10 ist dies beispielhaft mit der Phase 1, bezeichnet mit dem Bezugszeichen 20.1, der Fall. Die Phasen 2 bzw. 3 sind mit den Bezugszeichen 20.2 bzw. 20.3 in Fig. 10 gekennzeichnet.

Gemäß einer weiteren Variante des Messverfahrens im statischen Zustand des KSGs (der Reluktanzmaschine) 82 können auch nacheinander mehrere vordefinierte Winkellagen des Rotors relativ zum Stator eingestellt werden. Bei einer Reluktanzmaschine mit drei Phasen kann mittels der manuellen Durchdrehvorrichtung und einer Winkelskala erst eine Konjunktion des Rotors mit der Phase 1 des Stators eingestellt und die Stoßspannungsprüfung durchgeführt werden. Anschließend kann eine Konjunktion des Rotors mit der Phase 2 des Stators eingestellt und die Stoßspannungsprüfung durchgeführt werden. Schließlich kann eine Konjunktion des Rotors mit der Phase 3 des Stators eingestellt und die Stoßspannungsprüfung durchgeführt werden.

Eine manuelle Durchdrehvorrichtung ist in Figur 10 lediglich beispielhaft in Form des Ratschenwerkzeugs 100, das an sich aus der Praxis bekannt ist, gezeigt.

Obwohl die Erfindung unter Bezugnahme auf bestimmte Ausführungsbeispiele beschrieben worden ist, ist es für einen Fachmann ersichtlich, dass verschiedene Änderungen ausgeführt werden können und Äquivalente als Ersatz verwendet werden können, ohne den Bereich der Erfindung zu verlassen. Folglich soll die Erfindung nicht auf die offenbarten Ausführungsbeispiele begrenzt sein, sondern soll alle Ausführungsbeispiele umfassen, die in den Bereich der beigefügten Patentansprüche fallen. Insbesondere beansprucht die Erfindung auch Schutz für den Gegenstand und die Merkmale der Unteransprüche unabhängig von den in Bezug genommenen Ansprüchen.

### Bezugszeichenliste

- 1: Schwingungsantwort in erster Phase des Stators
- 2: Schwingungsantwort in zweiter Phase des Stators
- 3: Schwingungsantwort in dritter Phase des Stators
- 4: Schlagartiger Abfall der Spannungsantwort
- 20: KSG-Rotor
- 20.1: Phase 1
- 20.2: Phase 2
- 20.3: Phase 3
- 21: KSG-Stator
- 22: KSG-Gehäuse
- 23: Schraube
- 24: Schwungradgehäuse
- 25: Schwungrad
- 26: Zahnkranz für Starter
- 31, 51: Vergleichskriterium (Lage des Nulldurchgangs)
- 81: Kurbelwelle
- 82: Kurbelwellenstartergenerator (KSG)
- 83: Inverter
- 83a: Elektrische Leitungen
- 84: Starter-Motor
- 84a, 84b: Signalleitung
- 85: Schwungradvorrichtung
- 86: Getriebe
- 87: Service-Computer
- 89: Ritzel
- 90: Windungsprüfgerät
- 100: Manuelle Durchdrehvorrichtung
- 700: Verfahren zur elektrischen Funktionsprüfung
- 702: Schritt des Bereitstellens der Reluktanzmaschine
- 704: Schritt des Einstellens eines vordefinierten Rotorzustandes
- 706: Schritt der Durchführung einer Stoßspannungsprüfung

## Patentansprüche

1. Verfahren (700) zur elektrischen Funktionsprüfung, vorzugsweise zur Windungsgüteprüfung, einer elektrischen Reluktanzmaschine eines Kraftfahrzeugs, umfassend die folgenden Schritte:
Bereitstellen (701) der Reluktanzmaschine, aufweisend einen Rotor und einen Stator, in einem im Antriebsstrang des Kraftfahrzeugs eingebauten Zustand;
Einstellen (702) zumindest eines vordefinierten Rotorzustandes relativ zum Stator der Reluktanzmaschine; und
Durchführung (703) einer Stoßspannungsprüfung an der Reluktanzmaschine während der zumindest eine vordefinierte Rotorzustand eingestellt ist, wobei mindestens eine im Rahmen der Stoßspannungsprüfung erzeugte Schwingungsantwort der Reluktanzmaschine erfasst und anhand vorbestimmter Vergleichskriterien ausgewertet wird, um festzustellen, ob ein Defekt der Reluktanzmaschine vorliegt oder nicht.

2. Verfahren (700) nach Anspruch 1, wobei der zumindest eine vordefinierte Rotorzustand zumindest eine vordefinierte Winkellage des Rotors relativ zum Stator umfasst.

3. Verfahren (700) nach Anspruch 2, wobei die zumindest eine vordefinierte Winkellage
a) genau eine vordefinierte Winkellage des Rotors relativ zum Stator ist; oder
b) mindestens zwei, vorzugsweise genau drei, vordefinierte Winkellagen des Rotors relativ zum Stator umfasst, wobei für jede der vordefinierten Winkellagen jeweils mindestens eine im Rahmen der Stoßspannungsprüfung erzeugte Schwingungsantwort erfasst und ausgewertet wird.

4. Verfahren (700) nach Anspruch 1 oder 2, wobei
a) sich der Antriebsstrang bei der Durchführung der Stoßspannungsprüfung im Stillstand befindet, und/oder
b) der Rotor in der vordefinierten Winkellage kurzzeitig fixiert ist und eine Schwingungsantwort für jede Phase der Reluktanzmaschine erzeugt und erfasst wird.

5. Verfahren (700) nach einem der vorhergehenden Ansprüche, wobei der zumindest eine vordefinierte Rotorzustand zumindest eine vordefinierte Drehzahl des Rotors umfasst.

6. Verfahren (700) nach Anspruch 5, wobei der Antriebsstrang als hybridisierter Antriebsstrang ausgeführt ist, umfassend die Reluktanzmaschine und einen Verbrennungsmotor, wobei die zumindest eine vordefinierte Drehzahl des Rotors auf eine Drehzahl unterhalb der Leerlaufdrehzahl mittels einer elektrisch angetriebenen Durchdrehvorrichtung eingestellt wird und zur Durchführung der Stoßspannungsprüfung eine Befeuerung des Verbrennungsmotors unterbunden wird.

7. Verfahren (700) nach Anspruch 5, wobei der Antriebsstrang als hybridisierter Antriebsstrang ausgeführt ist, umfassend die Reluktanzmaschine und einen Verbrennungsmotor, wobei die zumindest eine vordefinierte Drehzahl des Rotors, beispielsweise umfassend eine Leerlaufdrehzahl des Antriebsstrangs, mittels eines befeuerten Betriebs des Verbrennungsmotors eingestellt wird.

8. Verfahren (700) nach Anspruch 7, wobei die zumindest eine vordefinierte Drehzahl des Rotors als ein vorbestimmter Drehzahlverlauf des Rotors eingestellt wird, vorzugsweise als eine Drehzahlverlaufskurve, wobei während des Durchlaufens des vorbestimmten Drehzahlverlaufs mehrere im Rahmen der Stoßspannungsprüfung erzeugte Schwingungsantworten erfasst und ausgewertet werden.

9. Verfahren (700) nach einem der vorhergehenden Ansprüche, wobei die Reluktanzmaschine ein Kurbelwellenstartergenerator ist und/oder wobei die Reluktanzmaschine zur Durchführung der Stoßspannungsprüfung von einem Inverter getrennt ist.

10. Verfahren (700) nach einem der vorhergehenden Ansprüche, ferner umfassend ein Erfassen eines aktuellen Werts mindestens eines Parameters, der die im Rahmen der Stoßspannungsprüfung erzeugte Schwingungsantwort beeinflusst, wobei der aktuelle Wert des Parameters in die Auswertung eingeht, um festzustellen, ob ein Defekt der Reluktanzmaschine vorliegt oder nicht.

11. Verfahren (700) nach Anspruch 10, wobei der mindestens eine Parameter einen Umgebungsparameter, vorzugsweise eine Temperatur oder eine Luftfeuchtigkeit, umfasst.

12. Verfahren (700) nach Anspruch 10 oder 11, wobei der mindestens eine Parameter mindestens einen die Reluktanzmaschine charakterisierenden Maschinenparameter umfasst, wobei der mindestens eine Maschinenparameter ein Alter, eine Laufzeit, eine Bauart, und/oder eine Kalibrierinformation der Reluktanzmaschine umfasst.

13. Verfahren (700) nach einem der vorhergehenden Ansprüche 10 bis 12, wobei der aktuelle Wert des Parameters in die Auswertung derart eingeht,
a) dass aus einer Menge zuvor hinterlegter Referenzmesswerte oder Referenz-Schwingungsantworten eine Teilmenge ausgewählt wird, die einer Referenzmessung mit dem aktuellen Wert des Parameters entspricht oder zumindest näherungsweise entspricht, und/oder
b) dass dieser zur Auswertung anhand der vorbestimmten Vergleichskriterien der erzeugten Schwingungsantwort der Reluktanzmaschine verwendet wird.

14. Verfahren (700) nach einem der vorhergehenden Ansprüche, wobei die vorbestimmten Vergleichskriterien anhand von zuvor durchgeführten Referenzmessungen festgelegt werden, wobei mindestens eine Referenz-Reluktanzmaschine in dem im Kraftfahrzeug eingebauten Zustand bereitgestellt wird und zur Durchführung der Referenzmessungen der mindestens eine vordefinierte Rotorzustand eingestellt wird und mindestens eine von einem Stoßspannungssignal erzeugte Schwingungsantwort der Referenz-Reluktanzmaschine erfasst wird, anhand derer die vorbestimmten Vergleichskriterien festgelegt werden.

15. Verfahren (700) nach Anspruch 14, wobei die mindestens eine erzeugte Schwingungsantwort der Referenz-Reluktanzmaschine als hinterlegte Referenzmessungen im Rahmen der Stoßspannungsprüfung mit der mindestens einen erzeugten Schwingungsantwort der Reluktanzmaschine anhand der vorbestimmten Vergleichskriterien verglichen wird.

16. Verfahren (700) nach einem der vorhergehenden Ansprüche, wobei das Verfahren jeweils für eine Mehrzahl von Reluktanzmaschinen durchgeführt wird und die hierbei erzeugte mindestens eine Schwingungsantwort jeweils an einen zentralen Datenspeicher übermittelt wird; und ferner umfassend:
Auswerten der in dem zentralen Datenspeicher hinterlegten Schwingungsantworten zur Verbesserung der vorbestimmten Vergleichskriterien.

17. Verfahren (700) nach einem der vorhergehenden Ansprüche, wobei die vorbestimmten Vergleichskriterien anhand von zuvor durchgeführten Referenzmessungen festgelegt werden, wobei mindestens eine Referenz-Reluktanzmaschine in dem im Kraftfahrzeug eingebautem Zustand bereitgestellt wird und zur Durchführungen der Referenzmessungen der mindestens eine vordefinierte Rotorzustand eingestellt wird und mindestens eine von einem Stoßspannungssignal erzeugte Schwingungsantwort der Referenz-Reluktanzmaschine erfasst wird, anhand derer die vorbestimmten Vergleichskriterien festgelegt werden.

18. Verfahren (700) nach Anspruch 14 oder 15, wobei die mindestens eine bereitgestellte Referenz-Reluktanzmaschine umfasst:
a) eine erste Referenz-Reluktanzmaschine im nicht-defekten Zustand; und/oder
b1) eine zweite Referenz-Reluktanzmaschine im defekten Zustand, oder
b2) mehrere zweite Referenz-Reluktanzmaschinen im defekten Zustand, wobei die mehreren zweiten Referenz-Reluktanzmaschinen unterschiedliche bekannte Defektzustände aufweisen.

19. Verfahren (700) nach einem der Ansprüche 2 bis 18, wobei der Antriebsstrang als hybridisierter Antriebsstrang ausgeführt ist, umfassend die als Kurbelwellenstartergenerator ausgeführte Reluktanzmaschine und einen Verbrennungsmotor, wobei die zumindest eine vordefinierte Winkellage des Rotors relativ zum Stator durch eine von mehreren möglichen Ruhepositionen des Verbrennungsmotors festgelegt ist, die sich durch eine Auspendelbewegung des Verbrennungsmotors nach einem Motorstopp des Verbrennungsmotors einstellt.
